(19) **Europäisches Patentamt**

**European Patent Office**

**Office européen des brevets**

(11) **EP 0 717 502 B1**

(12) **FASCICULE DE BREVET EUROPEEN**

(45) Date de publication et mention
de la délivrance du brevet:
**02.04.2003 Bulletin 2003/14**

(51) Int Cl.⁷: **H03L 7/197**, H03D 7/16

(21) Numéro de dépôt: **95402791.8**

(22) Date de dépôt: **12.12.1995**

(54) **Dispositif de synthèse de fréquence pour récepteur V/UHF large bande**

Frequenzsynthetisierer für einen VHF-UHF Breitbandempfänger

Frequency synthesiser for a broadband VHF-UHF receiver

(84) Etats contractants désignés:
**DE GB IT**

(72) Inventeurs:
 • **Roullet, André, Thomson-CSF, SCPI**
   **F-92402 Courbevoie Cedex (FR)**
 • **Peris, Daniel, Thomson-CSF, SCPI**
   **F-92402 Courbevoie Cedex (FR)**

(30) Priorité: **16.12.1994 FR 9415169**

(43) Date de publication de la demande:
**19.06.1996 Bulletin 1996/25**

(73) Titulaire: **Thales**
**75008 Paris (FR)**

(56) Documents cités:
**EP-A- 0 385 181        EP-A- 0 434 527**
**EP-A- 0 538 903        WO-A-84/04637**

**Description**

La présente invention concerne un dispositif de synthèse de fréquence pour récepteur V/UHF large bande.

Elle s'applique notamment à la réalisation d'un récepteur numérique V/UHF fonctionnant en évasion de fréquence dans la gamme des fréquences 20 MHz-3 GHz avec une première fréquence intermédiaire élevée supérieure à la plus haute des fréquences que peut recevoir le récepteur.

Dans ces récepteurs le fait d'utiliser une première fréquence intermédiaire supérieure à la plus haute des fréquences que peut recevoir le récepteur présente l'avantage de simplifier le filtrage amont entre l'antenne de réception et le premier étage mélangeur de fréquence. Cette solution présente cependant l'inconvénient qu'elle rend les récepteurs très sensibles aux brouilleurs, ceux-ci pouvant être très facilement transposés dans la bande de réception, lorsque la bande de bruit de l'oscillateur local qui attaque le premier étage mélangeur du récepteur, est importante ou encore lorsque la fréquence de cet oscillateur n'est pas stable. Ces conditions nuisent alors à la qualité spectrale et par conséquent à l'intégrité du signal démodulé par le récepteur. Dans les récepteurs numériques cette dégradation du signal qui est restituée par la chaîne de démodulation du récepteur est naturellement cause d'erreur et de perte d'information.

Pour pallier ces inconvénients une solution déjà préconisée par M. WADLEY en 1954 et qui est décrite dans un article de la revue "The transactions of the S.A. Institute of Electrical Engineers" intitulé "Variable frequency crystal-controlled receivers, and generators" consiste à hétérodiner le signal d'antenne avec un oscillateur libre à fréquence variable pour fournir une première fréquence intermédiaire, ce même oscillateur étant hétérodiné avec un spectre d'harmonique dont le résultat est filtré par un filtre à bande étroite pour être appliqué ensuite à un troisième mélangeur qui reçoit par ailleurs le résultat du premier mélange. Dans cette configuration, la dérive et le bruit de phase de l'oscillateur libre à fréquence variable se trouvent en grande partie éliminés. Cependant lorsque cette solution est appliquée à un récepteur V/UHF à large bande RF, elle fait apparaître de sérieuses difficultés de réalisation notamment du premier oscillateur dont la stabilité en fréquence doit être meilleure que $10^{-3}$ ainsi que de celle des filtres passe-bande qui doivent satisfaire à des contraintes de stabilité et de gabarit très sévères.

D'autres solutions du type de celle connue de la demande de brevet EP 0 385 181 pour réaliser des synthétiseurs de fréquence à fréquence plus basse ne conviennent pas non plus, car il n'existe aucun diviseur à rang variable capable de fonctionner à des fréquences aussi élevées que 7,5 GHz.

Le but de l'invention est de pallier les inconvénients précités.

A cet effet, l'invention a pour objet un dispositif de synthèse de fréquence pour récepteur V/UHF large bande comportant un premier étage mélangeur de fréquence pour transposer le signal large bande appliqué sur le récepteur en un premier signal à fréquence intermédiaire et un deuxième étage mélangeur de fréquence couplé en sortie du premier étage mélangeur de fréquence pour transposer le premier signal à fréquence intermédiaire en un deuxième signal à fréquence intermédiaire, comportant une première boucle de synthèse de fréquence pour appliquer un premier signal de transposition à large bande de fréquence sur une entrée du premier étage mélangeur et une deuxième boucle de fréquence de synthèse pour appliquer un deuxième signal de transposition à bande de fréquence étroite sur une entrée du deuxième étage mélangeur, une source commune de fréquence délivrant une fréquence de référence caractérisé en ce que :

- Il comporte un circuit multiplicateur double en liaison avec la source commune de fréquence et les deux boucles de synthèse de fréquence, le circuit multiplicateur double est associé à un premier filtre afin de fournir un signal de transposition à une fréquence correspondant à la fréquence de référence multipliée par un coefficient N1 et à un deuxième filtre afin de fournir un signal de transposition à une fréquence correspondant à la fréquence de référence multipliée par un coefficient N2, N1 étant différent de N2,
- Le premier filtre est relié à un mélangeur disposé dans la première boucle de synthèse de fréquence et le deuxième filtre est relié à un mélangeur disposé dans la deuxième boucle de synthèse de fréquence.

L'invention a pour avantage qu'elle permet une synthèse rapide de fréquence, par exemple entre 4,5 à 7,5 GHz, avec un bruit de phase très faible de l'ordre de -120 Dbc/Hz à ±3 dB à 20 KHz de la porteuse pour des récepteurs V/UHF à très large bande.

D'autres caractéristiques et avantages de l'invention apparaîtront dans la description qui suit, faite en regard des figures des dessins annexés qui représentent :

- La figure 1 un mode de réalisation d'un dispositif de synthèse de fréquences selon l'invention appliqué à la réalisation d'un récepteur V/UHF large bande.
- La figure 2 un tableau illustrant un mode de découpage des fréquences d'un récepteur en 4 sous gammes.
- La figure 3 un mode de réalisation du diviseur de fréquence programmable mis en oeuvre dans le mode de réalisation de la figure 1.

- La figure 4 un schéma simplifié équivalent du mode de réalisation de la figure 1.

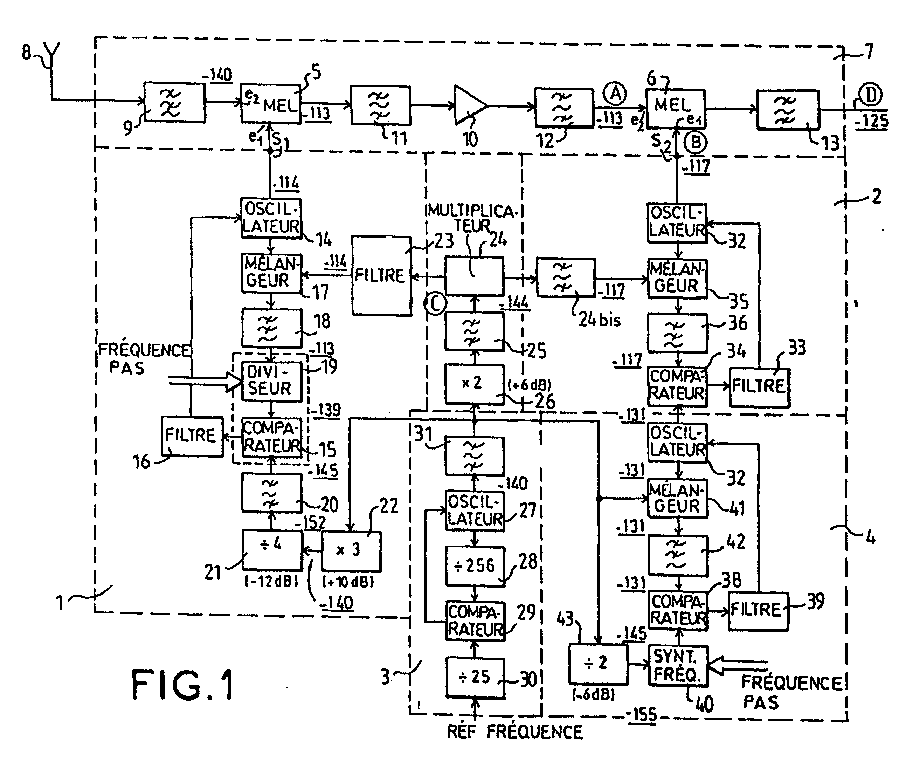

Le dispositif de synthèse de fréquences selon l'invention qui est représenté à la figure 1 comporte, représentées à l'intérieur de lignes fermées en pointillées, une première boucle de synthèse de fréquence à division fractionnaire 1 et une deuxième boucle de synthèse de fréquence à verrouillage de phase 2. Le signal fixant la fréquence de référence de chacune des boucles 1 et 2 est obtenu à partir d'une source commune 3 génératrice d'une fréquence de référence à faible bruit de phase. Une troisième boucle 4 à verrouillage de phase est disposée à la sortie de la source de référence 3 pour appliquer à l'entrée de la deuxième boucle 2 un signal de référence adapté aux caractéristiques de fonctionnement de la deuxième boucle 2. Les sorties $S_1$ et $S_2$ respectivement de la première boucle 1 et de la deuxième boucle 2 sont couplées respectivement aux entrées $e_1$ d'un premier étage 5 et d'un deuxième étage 6 mélangeur de fréquence d'une chaîne de réception à fréquence intermédiaire 7 d'un récepteur radioélectrique VHF/UHF à large bande. L'étage mélangeur 5 reçoit sur une deuxième entrée $e_2$ un signal obtenu à la sortie d'une antenne 8 et filtré par l'intermédiaire d'un filtre passe-bas 9. Le signal obtenu à la sortie de l'étage mélangeur 5 est appliqué à une deuxième entrée $e_2$ de l'étage mélangeur 6 après avoir été amplifié par un amplificateur à fréquence intermédiaire 10 interposé entre deux filtres passe-bande 11 et 12. Un filtre passe-bande 13 centré sur une deuxième fréquence intermédiaire est disposé en sortie du deuxième étage mélangeur 6.

Selon un mode préféré de réalisation de l'invention, la boude 1 permet de synthétiser des fréquences dans une très large bande comprise entre 4,5 et 7,5 GHz avec un pas de synthèse de 10 MHz et la boucle 2 permet la synthèse de fréquences dans une bande de ±5 MHz autour d'une fréquence centrale de 4,4 GHz avec un pas de synthèse de 25 KHz.

Pour parvenir à ces résultats la boucle 1 n'est pas réalisée, comme cela a lieu classiquement pour des fréquences plus basses, à l'aide d'une boucle composée d'un oscillateur commandé en tension par la sortie d'un comparateur phase fréquence et d'un diviseur à rang variable dont le rang de division est fixé par le rapport entre la fréquence à synthétiser et une fréquence de référence fixe, du fait qu'il n'existe pas de diviseur à rang variable capable de fonctionner à des fréquences aussi élevées que 7,5 GHz et que dans l'hypothèse où de tels diviseurs existeraient ceux-ci ne pourraient cependant pas convenir car leur rang de division trop élevé serait la cause d'un bruit de phase ramené à la sortie de l'oscillateur trop important

De façon différente la boucle 1 comporte un oscillateur à fréquence variable 14 commandé en tension par un signal fourni par la sortie d'un comparateur phase-fréquence 15 filtré par un filtre de bande 16. Le signal obtenu en sortie de l'oscillateur 14 est appliqué d'une part, sur l'entrée $e_1$ de l'étage mélangeur 5 et d'autre part, sur une première entrée du comparateur de phase 15 après avoir été successivement transposé en fréquence par un étage mélangeur 17, filtré par un filtre passe-bas 18 puis divisé en fréquence par un diviseur à rang variable à division fractionnaire 19. La deuxième entrée du comparateur de phase 15 reçoit le signal de référence de fréquence de la boucle 1.

Ce signal de référence est obtenu à la sortie d'un filtre passe-bande 20 couplé en sortie de la source de référence 3 par l'intermédiaire d'un circuit diviseur 21 et d'un circuit multiplieur 22. La transposition de la fréquence de l'oscillateur 14 qui est appliquée sur l'étage mélangeur 17, a lieu en appliquant sur une deuxième entrée de l'étage mélangeur 17 et après filtrage par un filtre 23, un signal fourni par la sortie d'un circuit multiplicateur de fréquence 24 double composé de façon connue par un générateur d'harmoniques.

L'entrée du circuit multiplicateur 24 est couplée à la sortie de la source de fréquence 3 par l'intermédiaire d'un filtre passe-bande 25 et d'un circuit multiplicateur par deux 26 reliés dans cet ordre en série.

La source 3 génératrice de la fréquence de référence se compose d'une boucle à verrouillage de phase formée de façon connue par un oscillateur à quartz commandé en tension 27, un diviseur de fréquence 28 et d'un comparateur phase fréquence 29. La référence de fréquence appliquée à l'entrée de la boucle sur le comparateur de phase fréquence 29 est obtenue à partir d'une source de référence externe de fréquence divisée par un circuit diviseur 30. Un filtre à quartz 31 est placé entre la sortie de l'oscillateur 27 et les entrées respectives des circuits multiplieurs 22 et 26.

La boucle de synthèse 2 comporte un oscillateur commandé en tension 32 par la sortie d'un filtre de boucle 33 disposé entre l'oscillateur 32 et la sortie d'un comparateur de phase 34.

Un étage de transposition de fréquence 35 est couplé par une première entrée entre la sortie de l'oscillateur 32 et une première entrée du comparateur de phase 34 par l'intermédiaire d'un filtre 36, et par une deuxième entrée à la sortie du circuit multiplieur 24 par l'intermédiaire du filtre 24bis. La deuxième entrée du comparateur de phase 34 est reliée à la sortie de la troisième boude 4 à verrouillage de phase. Cette troisième boucle 4 fournit un signal de fréquence de référence sur la deuxième entrée du comparateur de phase fréquence 34. Elle comporte un oscillateur 37 commandé en tension par la sortie d'un comparateur de phase fréquence 38 au travers d'un filtre 39. Le comparateur 38 reçoit sur une première entrée une fréquence de référence fournie par un synthétiseur de fréquence numérique 40 et sur une deuxième entrée une fréquence transposée de la fréquence de l'oscillateur 37 par un étage mélangeur 41 qui délivre cette fréquence au travers d'un filtre 42. La transposition de fréquence dans le mélangeur 41 est obtenue par mélange de la fréquence de l'oscillateur 37 avec la fréquence fournie à la sortie du filtre 31 de la source de fréquence 3. Le synthétiseur de fréquence 40 est synchronisé par la sortie d'un étage diviseur 43 de la fréquence fournie par la sortie du filtre 31.

Pour faire parcourir à l'oscillateur 14 de la boucle 1 la bande des fréquences comprises entre 4,5 et 7,5 GHz cette bande est découpée en sous gammes de fréquences. Ce découpage est guidé par le rang minimum, par exemple N = 6, qui peut être donné au diviseur à rang variable 19, par la fréquence maximale de fonctionnement du diviseur qui peut être estimée en fonction des possibilités technologiques actuelles de 1,7 à 2 GHz et par le régime transitoire de l'oscillateur 14 lorsque celui-ci est sollicité par une commande de changement de fréquence.

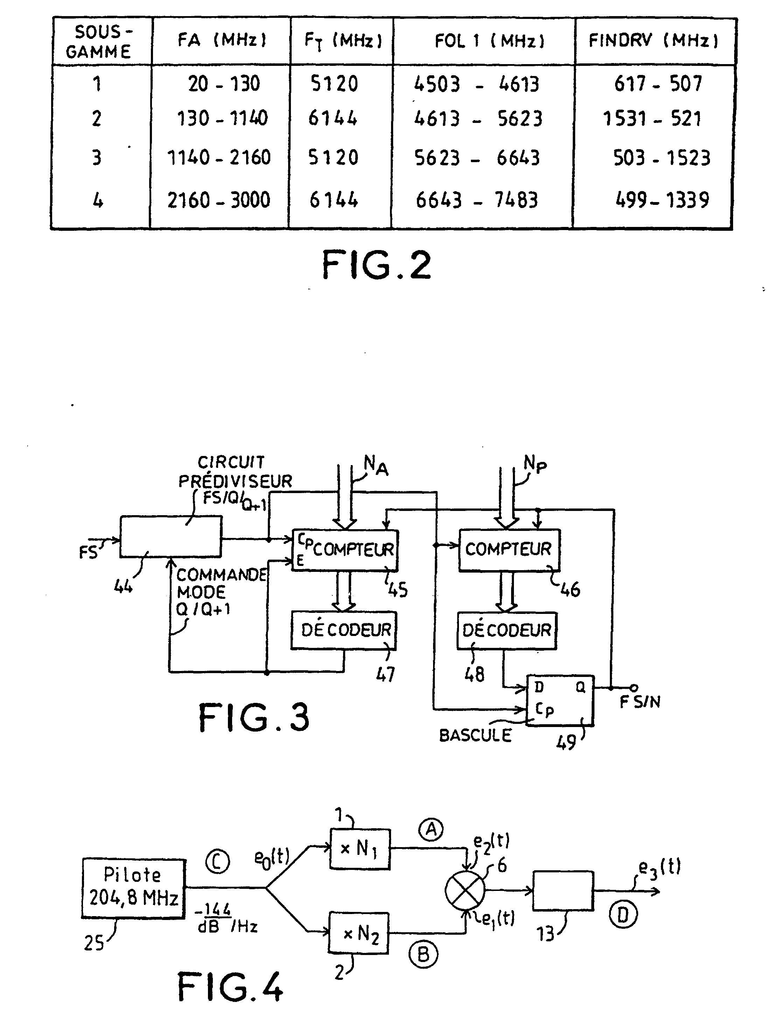

Le tableau de la figure 2 illustre un mode de découpage possible des fréquences en 4 sous gammes. Dans ce tableau :

- $F_A$ désigne la fréquence d'accord du récepteur (fréquence antenne),
- $F_T$ est la fréquence de transposition du signal appliqué sur l'étage mélangeur 17 de la boucle 1 obtenue par multiplication de la fréquence de référence à 102,4 MHz fourni par l'oscillateur 27 de la source commune 3,
- $F_{OL1}$ est la fréquence synthétisée par l'oscillateur 14,
- $F_{INDRV}$ désigne la fréquence d'entrée du diviseur à rang variable 19.

Le diviseur à rang variable à division fractionnaire 19 qui est représenté à la figure 3 comporte de façon connue et telle que décrite dans le brevet FR 2 656 480 un circuit prédiviseur 44 à deux modulo Q/Q+1 et deux compteurs synchrones programmables 45 et 46 couplés à la sortie du circuit prédiviseur 44. Le circuit prédiviseur 44 est par exemple formé d'un ensemble de bascules montées en anneau de Johnson dans lesquelles seuls Q+1 états sont conservés pour permettre la réalisation d'un diviseur à deux modulo Q et Q+1. La fréquence $F_S$ du signal fourni par la sortie du filtre 18 sur la figure 1 est ainsi divisée par Q ou Q+1 par le circuit prédiviseur 44. Le signal résultant de cette division est appliqué aux entrées de comptage des compteurs 45 et 46 qui sont programmées à des valeurs respectives $N_A$ et $N_P$, pour décompter simultanément à partir de ces valeurs, dès le début du cycle de division par Q+1 et tant que le nombre $N_A$ n'a pas été décompté à zéro par le compteur 45. Lorsque cela se produit, le décomptage du compteur 45 est arrêté et le rang de division du prédiviseur 44 est positionné sur Q par la sortie d'un décodeur 47 de l'état zéro qui commande également l'inhibition sur son entrée E du compteur 45 et le chargement du mode de division du prédiviseur 44. A l'instant d'apparition - de l'état zéro il y a $(Q+1)xN_A$ impulsions de fréquence $F_S$ comptées. Le décomptage du nombre $N_P$ par le compteur 46 se poursuit jusqu'à l'état 2 du compteur décodé par un décodeur 48 placé sur sa sortie. Le décodage de l'état 2 constitue une information de fin de cycle de division. Celle-ci est synchronisée sur le front montant de l'horloge de sortie du prédiviseur 44 et commande le rechargement des compteurs 45 et 46 par l'intermédiaire d'une bascule 49, qui change d'état en synchronisme avec cette horloge, aux valeurs initiales $N_A$ et $N_P$.

Après l'instant de fin de cycle le compteur 45 est à nouveau débloqué, le prédiviseur 44 est repositionné pour diviser par Q+1 et le cycle recommence. Le nombre total N d'impulsions de fréquence $F_S$ comptées au cours d'un cycle de division est par conséquent :

$$N=(Q+1)N_A+(N_P-N_A)Q = Q\,N_P + N_A$$

Un des principaux intérêts du dispositif de synthèse qui vient d'être décrit est qu'il permet une amélioration notable du bruit de phase en sortie du filtre à fréquence intermédiaire 13. Ceci est notamment mis en évidence ci-après à l'aide du schéma équivalent de la figure 4. En considérant que les boucles de synthèse 1 et 2 qui asservissent les oscillateurs 14 et 32 ramènent des bruits additifs toujours plus faibles que les bruits en sortie des filtres 23 et 24bis, puisque par conception les bruits de phase en sortie de ces filtres sont corrélés en phase comme provenant de la même source 3, il s'ensuit que les bruits des oscillateurs 14 et 32 ont les mêmes niveaux que les bruits issus des filtres 23 et 24bis. Dans ces conditions si la chaîne de réception n'amène pas de dégradations supplémentaires, le bruit de l'oscillateur 14 se retrouve normalement en (A) à rentrée $e_2$ de l'étage mélangeur 6. Le bruit de l'oscillateur 32 est quand à lui appliqué en (B) à l'entrée $e_1$ de l'étage mélangeur 6. En se reportant au schéma de la figure 4, où les éléments homologues à ceux de la figure 1 sont représentés avec les mêmes références, et en considérant que le signal en (C) obtenu à la sortie du filtre 25 est de la forme

$$e_0(t) = \cos(\omega_{ot} + m_o \sin\alpha\Omega t) \tag{1}$$

où $\omega_o$ est la pulsation de la porteuse d'origine fournie à la sortie du filtre 25
et $m_o \sin \Omega t$ représente de la modulation parasite composée de bruit - et de raies.

En désignant par $N_1$ et $N_2$ les rapports des fréquences synthétisées par les oscillateurs 14 et 32 avec la fréquence fournie en sortie du filtre 25.

les signaux obtenus aux points (A) et (B) sont alors de la forme

$$e_1(t) = \cos(N_1\,\omega_o t + N_1\,m_o\,\sin\Omega t) \tag{2}$$

et

$$e_2(t) = \cos(N_2\,\omega_o t + N_2\,m_o\,\sin\Omega t) \tag{3}$$

Après mélange et filtrage passe bande de la composante différence de fréquence au travers du mélangeur 6 et de l'étage 13 le signal obtenu en (D) est de la forme

$$e_3(t)=\frac{1}{2}\cos[(N_1\text{-}N_2)\omega_{ot} + (N_1\text{-}N_2)m_o\,\sin\Omega t] \tag{4}$$

La relation (4) fait apparaître que l'indice de modulation de la porteuse d'origine est augmenté de la grandeur $N_1\text{-}N_2$, soit de $20\log(N_1\text{-}N_2)$dB. Ceci revient à dire, en considérant pour simplifier qu'il y a absence de non linéarités et aucune différence de retard entre voies, que le bruit de phase du signal disponible en (D) est égal au bruit de phase du signal en (C) dégradé de $20\log(N_1\text{-}N_2)$dB. Ainsi le bruit de phase obtenu en (D) est plus faible que le plus faible des bruits de phase des signaux présentés aux entrées du mélangeur 6.

Un exemple de répartition des niveaux de bruit en dBc/Hz est indiqué sur la figure 1, soit par des chiffres entre parenthèses indiquant en dB une dégradation ou un gain, soit par des chiffres soulignés indiquant les planchers de bruit notamment au niveau des comparateurs de phase 15 et 34, du diviseur à rang variable 19 et du dispositif de synthèse direct 35, pour les conditions de fonctionnement suivantes :

- Fréquence du signal d'antenne fourni par la sortie du filtre 9
    = 2018 MHz
- Fréquence du signal de transposition fourni par la sortie du filtre 23
    = 6144 MHz
- Fréquence du signal fourni par l'oscillateur 14
    = 4684,8 MHz
- Fréquence appliquée à l'entrée du diviseur à rang variable
    = 1459,2 MHz
- Rang de division du diviseur à rang variable 19
    = 19
- Fréquence du signal obtenu en sortie de l'oscillateur 32
    = 4413 MHz
- Fréquence du signal obtenu en sortie du filtre à fréquence intermédiaire 13
    = 70 MHz
- Fréquence du signal de référence appliqué à l'entrée du diviseur 30
    = 10 MHz
- Rapport de division du diviseur 30
    = 25
- Rapport de division du diviseur 28
    = 256
- Fréquence du signal appliqué à l'entrée du multiplieur 24
    = 204,8 MHz
- Rang de multiplication $N_1$ (fig.4)
    = 30
- Rang de multiplication $N_2$ (fig 4)
    =21
- Rang de multiplication du multiplieur 22
    =3
- Rang de division du diviseur 22

= 4
- Fréquence du signal fourni par l'oscillateur 37
   = 112,2 MHz

Toutes les valeurs du bruit de phase sont indiquées sur la figure 1 pour un écart de 20 KHz par rapport à la fréquence porteuse du signal correspondant.

La valeur de bruit obtenue en sortie de l'oscillateur 14 est de -114 dBc/Hz. S'il n'y avait pas de transposition de fréquence effectuée par l'étage mélangeur 17, le bruit de phase en sortie de l'oscillateur 14 serait égal à -119 dBc/Hz c'est-à-dire égal au bruit plancher du comparateur de phase 15 auquel il faut ajouter la quantité 20 log N où N est le rang de division du diviseur à rang variable 19. Avec N = 19 et un bruit plancher de -145 dBc/Hz le bruit à 20 KHz est dans ces conditions égal à -145 + 20 log 19 = -119 dBc/Hz. Cependant comme la valeur de bruit du signal de transposition obtenu en sortie du filtre 23 est égal à -114 dBc/HZ et est supérieur à -119 dBc/Hz c'est la valeur -114 dBc/Hz de son bruit propre qui est recopiée en sortie de l'oscillateur 14.

En estimant le bruit de la bouble 4 à -131 dBc/HZ ce même raisonnement appliqué à l'oscillateur 32 permet d'obtenir un bruit de -117 dBc/HZ qui est en fait le bruit prépondérant à considérer. Ces valeurs de bruit correspondent au bruit du signal de transposition fourni par la sortie de transposition appliqué sur l'étage mélangeur 36.

En admettant que la chaîne de réception 7 n'apporte pas de dégradation supplémentaire, les niveaux de bruit des oscillateurs 14 et 27 se retrouvent respectivement aux entrées $e_2$ et $e_1$ du mélangeur 6.

Avec les valeurs $N_1$ = 30 et $N_2$ = 21 l'indice de modulation est augmenté de la grandeur $N_1$-$N_2$ soit 20log $(N_1$-$N_2)$dB. Le bruit en (D) en sortie du filtre à fréquence intermédiaire est égal à -144 + 20log(30-21)= -125 dBc/Hz.

## Revendications

1. Dispositif de synthèse de fréquence pour récepteur V/UHF large bande comportant un premier étage mélangeur de fréquence (5) pour transposer le signal large bande appliqué sur le récepteur en un premier signal à fréquence intermédiaire et un deuxième étage mélangeur de fréquence (6) couplé en sortie du premier étage mélangeur de fréquence (5) pour transposer le premier signal à fréquence intermédiaire en un deuxième signal à fréquence intermédiaire **caractérisé en ce qu'**il comprend une première boucle de synthèse de fréquence (1) pour appliquer un premier signal de transposition à large bande de fréquence sur une entrée du premier étage mélangeur (5), une deuxième boucle de synthèse de fréquence (2) pour appliquer un deuxième signal de transposition à bande de fréquence étroite sur une entrée du deuxième étage mélangeur (6) et une source commune de fréquence (3) délivrant une fréquence de référence caractérisé en ce :

   • Il comporte un circuit multiplicateur double (24) en liaison avec la source commune de fréquence (3) et les deux boucles de synthèse de fréquence, le circuit multiplicateur double est associé à un premier filtre (23) afin de fournir un signal de transposition à une fréquence correspondant à la fréquence de référence multipliée par un coefficient N1 et à un deuxième filtre (24bis) afin de foumir un signal de transposition à une fréquence correspondant à la fréquence de référence multipliée par un coefficient N2, N1 étant différent de N2,
   • Le premier filtre (23) est relié à un mélangeur (17) disposé dans la première boucle de synthèse de fréquence et le deuxième filtre (24bis) est relié à un mélangeur (32) disposé dans la deuxième boucle de synthèse de fréquence.

2. Dispositif selon la revendication 1 **caractérisé en ce que** la première boucle de synthèse de fréquence (1) comprend :

   - un oscillateur commandé en tension (14) par un comparateur phase fréquence (15),
   - un diviseur à rang variable (19) à division fractionnaire couplé à une sortie de l'oscillateur commandé en tension (14) par l'intermédiaire d'un étage mélangeur de fréquence (17) pour transposer le signal fourni par l'oscillateur en une fréquence plus basse avec un signal de transposition dérivée du signal de référence fourni par la source commune de fréquence (3),
   - un comparateur phase fréquence (15) couplé par une première entrée en sortie du diviseur à rang variable (19) à division fractionnaire et par une deuxième entrée à la sortie de la source commune de fréquence (3) pour asservir la fréquence de l'oscillateur (14) sur une fréquence proportionnelle de la fréquence de référence de la source commune (3).

3. Dispositif selon l'une quelconque des revendications 1 à 2 **caractérisé en ce que** la deuxième boucle de synthèse de fréquence (2) comprend :

- un oscillateur commandé en tension (32)
- un comparateur phase fréquence couplé par une première entrée à une sortie de l'oscillateur (32), par l'intermédiaire d'un étage mélangeur de fréquence (35) transposant le signal fourni par l'oscillateur en un signal de fréquence plus basse, pour asservir l'oscillateur (32) sur une fréquence proportionnelle à la fréquence de référence du signal fourni par la source commune (3).

4. Dispositif selon la revendication 1 **caractérisé en ce que** le premier et le deuxième circuit multiplicateur (24, 23; 24, 24 bis) sont formés par un générateur d'harmonique du signal de référence couplé à des filtres d'harmonique (23 ; 24 bis).

5. Dispositif selon l'une quelconque des revendications 1 à 4 **caractérisé en ce que** la source commune de référence (3) comprend un oscillateur à quartz commandé en tension (27) couplé à une première entrée d'un comparateur phase fréquence (29) par l'intermédiaire d'un diviseur de fréquence (28), pour asservir la fréquence de l'oscillateur (27) sur une fréquence multiple d'une fréquence d'un signal de référence appliqué sur une deuxième entrée du comparateur de phase (29).

6. Dispositif selon l'une quelconque des revendications 3 à 5 **caractérisé en ce que** la deuxième entrée du comparateur phase fréquence (34) de la deuxième boucle de synthèse de fréquence est couplée à la sortie d'une troisième boucle à verrouillage de phase (4) fournissant une fréquence multiple de la fréquence de référence du signal foumi par la source commune (3).

7. Dispositif selon la revendication 6 **caractérisé en ce que** la troisième boucle à verrouillage de phase (4) comprend un étage mélangeur (41) interposé entre la sortie de l'oscillateur (37) et une première entrée d'un comparateur de phase (38) pour commander la fréquence de l'oscillateur (37) en comparant la fréquence du signal transposée par l'étage mélangeur (41) à la fréquence d'un signal de référence multiple de la fréquence du signal de référence foumi par la source commune (3) et appliqué sur sa deuxième entrée.

8. Dispositif selon la revendication 7 **caractérisé en ce que** le signal appliqué sur la deuxième entrée du comparateur de phase (38) est fourni par synthèse numérique directe.

9. Dispositif selon l'une quelconque des revendications 2 à 8 **caractérisé en ce que** le diviseur à rang variable (19) à division fractionnaire comprend un circuit prédiviseur (44) à deux modulo Q/Q+1 et deux compteurs synchrones programmables (45, 46) couplés à la sortie du circuit prédiviseur (44).

10. Utilisation du dispositif selon l'une quelconque des revendications 1 à 9 à la réalisation d'un récepteur V/UHF large bande ayant une première fréquence intermédiaire supérieure à la plus haute des fréquences que peut recevoir le récepteur.

**Claims**

1. Frequency synthesis device for broadband V/UHF receiver comprising a first frequency mixer stage (5) for transposing the broadband signal applied to the receiver into a first intermediate frequency signal and a second frequency mixer stage (6) coupled at the output of the first frequency mixer stage (5) for transposing the first intermediate frequency signal into a second intermediate frequency signal **characterized in that** it comprises a first frequency synthesis loop (1) for applying a first transposition signal with broad frequency band to an input of the first mixer stage (5), a second frequency synthesis loop (2) for applying a second transposition signal with narrow frequency band to an input of the second mixer stage (6) and a common frequency source (3) delivering a reference frequency, **characterized in that**:

   • it comprises a dual multiplier circuit (24) linked up with the common frequency source (3) and the two frequency synthesis loops, the dual multiplier circuit is associated with a first filter (23) so as to provide a transposition signal at a frequency corresponding to the reference frequency multiplied by a coefficient N1 and with a second filter (24 bis) so as to provide a transposition signal at a frequency corresponding to the reference frequency multiplied by a coefficient N2, N1 being different from N2,
   • the first filter (23) is linked to a mixer (17) disposed in the first frequency synthesis loop and the second filter (24 bis) is linked to a mixer (32) disposed in the second frequency synthesis loop.

2. Device according to Claim 1, **characterized in that** the first frequency synthesis loop (1) comprises:

- a voltage controlled oscillator (14) controlled by a phase frequency comparator (15),
- a fractional division variable-rank divider (19) coupled to an output of the voltage controlled oscillator (14) by way of a frequency mixer stage (17) for transposing the signal provided by the oscillator into a lower frequency with a transposition signal, derived from the reference signal provided by the common frequency source (3),
- a phase frequency comparator (15) coupled by a first input at the output of the fractional division variable-rank divider (19) and by a second input to the output of the common frequency source (3) for slaving the frequency of the oscillator (14) to a proportional frequency of the reference frequency of the common source (3).

3. Device according to any one of Claims 1 to 2, **characterized in that** the second frequency synthesis loop (2) comprises:

- a voltage controlled oscillator (32)
- a phase frequency comparator coupled by a first input to an output of the oscillator (32), by way of a frequency mixer stage (35) transposing the signal provided by the oscillator into a signal of lower frequency, for slaving the oscillator (32) to a frequency proportional to the reference frequency of the signal provided by the common source (3).

4. Device according to Claim 1, **characterized in that** the first and the second multiplier circuit (24, 23; 24, 24 bis) are formed by a reference signal harmonic generator coupled to harmonic filters (23; 24 bis).

5. Device according to any one of Claims 1 to 4, **characterized in that** the common reference source (3) comprises a voltage controlled quartz oscillator (27) coupled to a first input of a phase frequency comparator (29) by way of a frequency divider (28), for slaving the frequency of the oscillator (27) to a frequency which is a multiple of a frequency of a reference signal applied to a second input of the phase comparator (29).

6. Device according to any one of Claims 3 to 5, **characterized in that** the second input of the phase frequency comparator (34) of the second frequency synthesis loop is coupled to the output of a third phase locked loop (4) providing a frequency which is a multiple of the reference frequency of the signal provided by the common source (3).

7. Device according to Claim 6, **characterized in that** the third phase locked loop (4) comprises a mixer stage (41) interposed between the output of the oscillator (37) and a first input of a phase comparator (38) for controlling the frequency of the oscillator (37) by comparing the signal frequency transposed by the mixer stage (41) with the frequency of a reference signal which is a multiple of the frequency of the reference signal provided by the common source (3) and applied to its second input.

8. Device according to Claim 7, **characterized in that** the signal applied to the second input of the phase comparator (38) is provided by direct digital synthesis.

9. Device according to any one of Claims 2 to 8, **characterized in that** the fractional division variable-rank divider (19) comprises a two modulo Q/Q+1 predivider circuit (44) and two programmable synchronous counters (45, 46) coupled to the output of the predivider circuit (44).

10. Use of the device according to any one of Claims 1 to 9 in the embodying of a broadband V/UHF receiver having a first intermediate frequency greater than the highest of the frequencies which the receiver can receive.

**Patentansprüche**

1. Vorrichtung zur Frequenzsynthese für einen breitbandigen V/UHF-Empfänger, mit einer ersten Frequenzmischstufe (5) zur Umsetzung des an dem Empfänger ankommenden breitbandigen Signals in ein erstes Zwischenfrequenzsignal und mit einer zweiten Frequenzmischstufe (6), die an den Ausgang der ersten Frequenzmischstufe (5) gekoppelt ist, um das erste Zwischenfrequenzsignal in ein zweites Zwischenfrequenzsignals umzusetzen, wobei die Vorrichtung eine erste Frequenzsyntheseschleife (1), um ein erstes Umsetzungssignal mit breitem Frequenzband an einen Eingang der ersten Mischstufe (5) anzulegen, und eine zweite Frequenzsyntheseschleife (2) aufweist, um ein zweites Umsetzungssignal mit schmalem Frequenzband an einen Eingang der zweiten Mischstufe (6) anzulegen, wobei eine gemeinsame Frequenzquelle (3) eine Bezugsfrequenz liefert, **dadurch gekennzeichnet, daß**

- die Vorrichtung eine doppelte Multiplizierschaltung (24) in Verbindung mit der gemeinsamen Frequenzquelle (3) und den beiden Frequenzsyntheseschleifen enthält, wobei diese doppelte Multiplizierschaltung einem ersten Filter (23), um ein Umsetzungssignal auf eine Frequenz entsprechend der mit einem Faktor $N_1$ multiplizierten Bezugsfrequenz zu liefern, und einem zweiten Filter (24bis) zugeordnet ist, um ein Umsetzungssignal auf eine Frequenz entsprechend der mit einem Faktor $N_2$ multiplizierten Bezugsfrequenz zu liefern, wobei $N_1$ sich von $N_2$ unterscheidet;
- das erste Filter (23) mit einer Mischstufe (17) verbunden ist, die sich in der ersten Frequenzsyntheseschleife befindet, und das zweite Filter (24bis) mit einer Mischstufe (32) verbunden ist, die sich in der zweiten Frequenzsyntheseschleife befindet.

2. Vorrichtung nach Anspruch 1, **dadurch gekennzeichnet, daß** die erste Frequenzsyntheseschleife (1) aufweist:

- einen durch einen Phasen-Frequenzkomparator (15) spannungsgesteuerten Oszillator (14),
- einen Teiler (19) mit variablem, gebrochenem Teilerrang, der an einen Ausgang des spannungsgesteuerten Oszillators (14) über eine Frequenzmischstufe (17) gekoppelt ist, um das vom Oszillator gelieferte Signal in eine niedrigere Frequenz mit einem Umsetzungssignal umzusetzen, das vom Bezugssignal abgeleitet ist, welches von der gemeinsamen Frequenzquelle (3) geliefert wurde,
- einen Phasen-Frequenzkomparator (15), der mit einem ersten Eingang an den Ausgang des Teilers (19) mit variablem, gebrochenem Teilerrang und mit einem zweiten Eingang an den Ausgang der gemeinsamen Frequenzquelle (3) gekoppelt ist, um die Frequenz des Oszillators (14) auf eine Frequenz proportional zur Bezugsfrequenz der gemeinsamen Quelle (3) nachzuregeln.

3. Vorichtung nach einem beliebigen der Ansprüche 1 und 2, **dadurch gekennzeichnet, daß** die zweite Frequenzsyntheseschleife (2) enthält:

- einen spannungsgesteuerten Oszillator (32),
- einen Phasen-Frequenzkomparator, der mit einem ersten Eingang an den Ausgang des Oszillators (32) über eine Frequenzmischstufe (35) gekoppelt ist, die das vom Oszillator gelieferte Signal in ein Signal geringerer Frequenz umsetzt, um den Oszillator (32) auf eine Frequenz proportional zur Bezugsfrequenz des von der gemeinsamen Quelle (3) gelieferten Signals nachzuregeln.

4. Vorrichtung nach Anspruch 1, **dadurch gekennzeichnet, daß** die erste und die zweite Multiplizierschaltung (24, 23; 24, 24bis) von einem Oberwellengenerator für das Bezugssignal gebildet werden, der an Oberwellenfilter (23, 24bis) gekoppelt ist.

5. Vorrichtung nach einem beliebigen der Ansprüche 1 bis 4, **dadurch gekennzeichnet, daß** die gemeinsame Bezugsquelle (3) einen spannungsgesteuerten Quarzoszillator (27) aufweist, der an einen ersten Eingang eines Phasen-Frequenzkomparators (29) über einen Frequenzteiler (28) gekoppelt ist, um die Frequenz des Oszillators (27) auf eine Frequenz nachzuregeln, die ein Vielfaches einer Frequenz eines Bezugssignals bildet, welches an einen zweiten Eingang des Phasenkomparators (29) angelegt ist.

6. Vorrichtung nach einem beliebigen der Ansprüche 3 bis 5, **dadurch gekennzeichnet, daß** der zweite Eingang der Phasen-Frequenzkomparators (34)der zweiten Frequenzsyntheseschleife an den Ausgang einer dritten Phasenverriegelungsschleife (4) gekoppelt ist, welche eine Frequenz liefert, die ein Vielfaches der Bezugsfrequenz der gemeinsamen Quelle ist.

7. Vorrichtung nach Anspruch 6, **dadurch gekennzeichnet, daß** die dritte Phasenverriegelungsschleife (4) eine Mischstufe (41) enthält, die zwischen den Ausgang des Oszillators (37) und einen ersten Eingang eines Phasenkomparators (38) eingefügt ist, um die Frequenz des Oszillators (37) so zu steuern, daß die Frequenz des von der Mischstufe (41) umgesetzten Signals mit der Frequenz eines Bezugssignals verglichen wird, die ein Vielfaches der Frequenz des von der gemeinsamen Quelle (3) gelieferten und an dessen zweiten Eingang angelegten Bezugssignals ist.

8. Vorichtung nach Anspruch 7, **dadurch gekennzeichnet, daß** das an den zweiten Eingang des Phasenkomparators (38) angelegte Signal durch direkte digitale Synthese gebildet ist.

9. Vorrichtung nach einem beliebigen der Ansprüche 2 bis 8, **dadurch gekennzeichnet, daß** der Teiler (19) variablen und gebrochenen Rangs eine Vor-Teilerschaltung (44) mit zwei Teilermoduln Q und Q+1 und zwei programmierbare synchrone Zähler (45, 46) enthält, die an den Ausgang des Vor-Teilers (44) gekoppelt sind.

10. Verwendung der Vorrichtung nach einem beliebigen der Ansprüche 1 bis 9 zur Realisierung eines breitbandigen V/UHF-Empfängers, der eine erste Zwischenfrequenz besitzt, die höher als die höchste Frequenz ist, die der Empfänger empfangen kann.

FIG.1

| SOUS-GAMME | FA (MHz) | $F_T$ (MHz) | FOL 1 (MHz) | FINDRV (MHz) |
|------------|----------|-------------|-------------|--------------|
| 1 | 20 - 130 | 5120 | 4503 - 4613 | 617 - 507 |
| 2 | 130 - 1140 | 6144 | 4613 - 5623 | 1531 - 521 |
| 3 | 1140 - 2160 | 5120 | 5623 - 6643 | 503 - 1523 |
| 4 | 2160 - 3000 | 6144 | 6643 - 7483 | 499 - 1339 |

## FIG.2

## FIG.3

## FIG.4